# EUROPEAN PATENT APPLICATION

(11) **EP 2 765 609 A1**
(43) Date of publication of application: **13.08.2014**
(21) Application number: 14154437.9
(22) Date of filing: 10.02.2014
(51) Int. Cl.: H01L 27/32, H01L 27/28

(54) **Organic light emitting diode display apparatus with solar cell and method of manufacturing the same**

(30) Priority: 08.02.2013 KR 20130014307
(71) Applicant: Samsung Electronics Co., Ltd, Gyeonggi-do 443-742 (KR)
(72) Inventor: Lee, Yongman, 443-742 Gyeonggi-do (KR); Park, Dongyoul, 443-742 Gyeonggi-do (KR); Choi, Soonkyoung, 443-742 Gyeonggi-do (KR); Baek, Jaemyung, 443-742 Gyeonggi-do (KR)
(74) Representative: Gover, Richard Paul

(57) **Abstract**

An Organic Light Emitting Diode (OLED) display apparatus with a solar cell is provided. The OLED display apparatus includes an OLED display unit which includes a pixel region formed of an OLED and a pixel boundary region partitioning the pixel region, and provided with a touch panel through which light emitted from the OLED is transmitted and at least one glass; and a solar cell for converting incident light into electricity, which is formed adjacent to the OLED display unit.

## Description

### BACKGROUND OF THE INVENTION

### 1. Field of the Invention

The present invention generally relates to an Organic Light Emitting Diode (OLED) display apparatus with a solar cell and a method of manufacturing the same, and more particularly to an OLED display apparatus with solar cells in which the solar cell is formed in a pixel boundary region or on an upper portion of an OLED so as to improve light absorbing efficiency of the solar cell prepared for the OLED display apparatus and to assist electric power of the OLED display apparatus, thereby increasing use time of electric power.

### 2. Description of the Related Art

With the development of technologies relating to portable multimedia devices, a display apparatus using an OLED has been developed, which has an advantage of a wide viewing angle, a high response rate, self-light emission, low energy consumption and the like.

Such an OLED display apparatus has been applied to laptop computers, portable phones, MP3 players, Portable Multimedia Players (PMP) and the like, which are supplied with electric power from a rechargeable battery. The use time of the electronic device is determined by a charging capacity of a battery. Therefore, development of a technology for increasing battery capacity to enable longer use time of the electronic device has been required. Conventionally, research has focused on developing a technology for operating a display apparatus at low electric power and to develop an algorithm for saving electric power. Basically, there is a problem in extending the limited charging capacity of the battery.

Recently, a method of supplying electric power to a portable device or for charging a battery for the portable device by using solar light has been developed, in which a solar cell is attached to a surface of the portable device.

In the prior art, Korean Patent Application No. 2005-0035595 discloses a technology for forming a solar cell and an Organic Light Emitting Diode (OLED) on an identical substrate, in which the technology a solar cell is made of amorphous silicon. However, there is a problem in that separate spaces for the solar cell and a display unit are required. Practical use of space and practicality of the electronic device are decreased.

### SUMMARY OF THE INVENTION

The present invention has been made to solve the above-mentioned problems in the prior art, and to provide at least the advantages described below. Accordingly, an aspect of the present invention is to provide an Organic Light Emitting Diode (OLED) display apparatus with a solar cell and a method of manufacturing the same, in which the solar cell assists electric power of the display apparatus.

Another aspect of the present invention is to provide an Organic Light Emitting Diode (OLED) display apparatus with a solar cell and a method of manufacturing the same, in which the display apparatus has a reduced thickness, and the solar cell has improved light absorbing efficiency.

In accordance with an aspect of the present invention, an Organic Light Emitting Diode (OLED) display apparatus with a solar cell is provided. The OLED display apparatus includes an OLED display unit which includes a pixel region formed of an OLED and a pixel boundary region partitioning the pixel region, and a touch panel through which light emitted from the OLED is transmitted, and at least one glass; and a solar cell for converting incident light into electricity, formed adjacent to the OLED display unit.

In accordance with another aspect of the present invention, a method of manufacturing an OLED display apparatus with a solar cell is provided. The method includes forming a solar cell on a substrate; forming an OLED on the solar cell; and forming at least one glass and a touch panel through which light emitted from the OLED is transmitted, on the OLED.

In accordance with still another aspect of the present invention, a method of manufacturing an OLED display apparatus with a solar cell is provided. The method includes forming a solar cell on a substrate; etching a part of the solar cell; forming an isolation layer on the etched part of the solar cell and an OLED on the isolation layer; and forming at least one glass and a touch panel through which light emitted from the OLED is transmitted, on the OLED.

In accordance with still another aspect of the present invention, a method of manufacturing an OLED display apparatus with a solar cell is provided. The method includes forming an OLED in a pixel region on a substrate, except for a pixel boundary region; forming a top glass on the pixel region and the pixel boundary region; forming a solar cell on the top glass; and forming a touch panel and a cover glass on the solar cell.

In accordance with still another aspect of the present invention, a method of manufacturing an OLED display apparatus with a solar cell is provided. The method includes preparing a lower structure by forming an OLED in a pixel region on a substrate, except for a pixel boundary region, and forming a top glass on the pixel region and the pixel boundary region; preparing an upper structure in which a cover glass, a touch panel and a solar cell are sequentially formed, separately from the lower structure; and enabling the upper structure to cohere on the lower structure by turning the upper structure upside-down.

### BRIEF DESCRIPTION OF THE DRAWINGS

The above and other aspects, features, and advantages of the present invention will be more apparent from the following detailed description taken in conjunction with the accompanying drawings, in which:
FIGS. 1 - 6 are sectional views illustrating an OLED display apparatus including a solar cell according to an embodiment of the present invention; and
FIGS. 7-10 are sectional views illustrating an OLED display apparatus including a solar cell according to another embodiment of the present invention.

### DETAILED DESCRIPTION OF EMBODIMENTS OF THE PRESENT INVENTION

In the following description of the present invention, a detailed description of related well-known functions or structures incorporated herein will be omitted when it may make the subject matter of the present invention unclear. In the description of the present invention, terms or words used hereinafter should be interpreted not as general or having general dictionary meanings, but according to the meanings and concepts suitable for the technical spirit of the present invention. Thus, since the following description and the accompanying drawings do not represent all technical aspects of the present invention, but merely indicate embodiments of the present invention, it should be understood that there may be various equivalents and modifications which can be substituted for the embodiments at a time of filing this application. Furthermore, in the accompanying drawings, some structural elements may be exaggeratingly or schematically shown, or may be omitted.

In an embodiment of the present invention, the OLED display apparatus with a solar cell may be applied to all portable electronic information and communication devices, multimedia devices and applications thereof, such as a portable phone, a television receiver (TV), a tablet Personal Computer (PC), a mobile communication terminal, a mobile phone, a laptop PC, a Personal Digital Assistant (PDA), a smart phone, an International Mobile Telecommunication 2000 (IMT-2000) terminal, a Code Division Multiple Access (CDMA) terminal, a Wideband Code Division Multiple Access (WCDMA) terminal, a Global System for Mobile communication (GSM) terminal, a General Packet Radio Service (GPRS) terminal, an Enhanced Data rates for GSM Evolution (EDGE) terminal, an Universal Mobile Telecommunication Service (UMTS) terminal, a digital broadcasting terminal and an Automated Teller Machine (ATM).

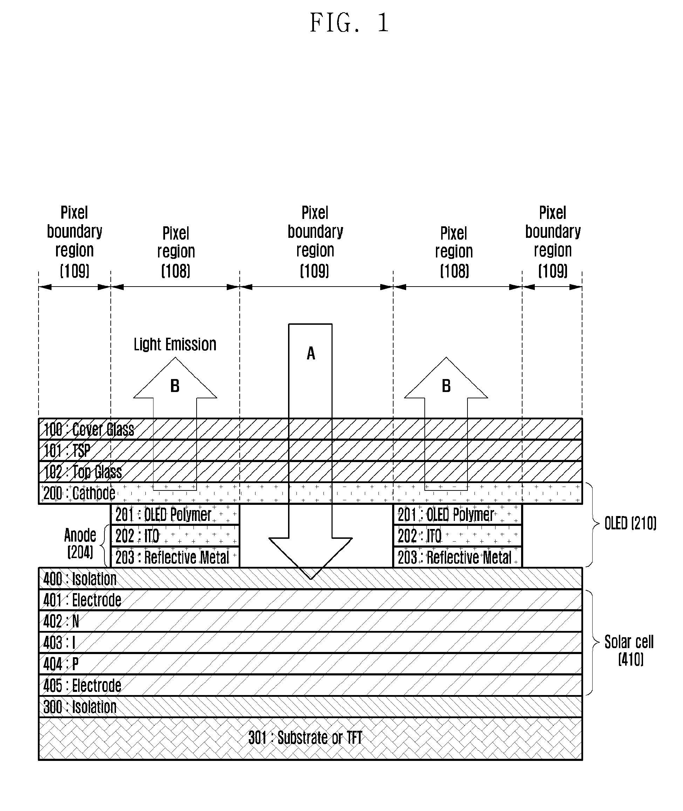

FIG. 1 is a sectional view illustrating an OLED display apparatus with a solar cell according to an embodiment of the present invention.

Referring to FIG. 1, the OLED display apparatus with the solar cell according to an embodiment of the present invention includes a cover glass 100, a touch panel 101, a top glass 102, an Organic Light Emitting Diode (OLED) 210, a solar cell 410, a first isolation layer 400, a second isolation layer 300 and a circuit board 301.

The top glass 102, the touch panel 101 and the cover glass 100 may be sequentially arranged on a cathode 200 constituting the OLED 210.

The OLED 210 is a device which is supplied with electric power from a battery or an external electric power supplying unit and emits light depending on a flow of electric current so as to display desired image information.

The OLED 210 includes a cathode region 200 comprising a transparent Indium Tin Oxide (ITO) electrode or a semitransparent ITO electrode, a polymer region 201 for emitting light, and anode region 204 comprising a transparent ITO electrode or a reflective metal. Here, the transparent ITO electrode 202 of the anode region 204 may be omitted.

The anode region 204 may be formed of a transparent conductive material. The transparent conductive material includes Indium Tin Oxide (ITO), Tin Oxide (TO), Indium Zinc Oxide (IZO), Indium Tin Zinc Oxide (ITZO), or a combination thereof.

The OLED 210 may include a Hole Injection Layer (HIL), a Hole Transporting Layer (HTL), an Emission Layer (EML), an Electron Transporting Layer (ETL), and an Electron Injection Layer (EIL).

The cathode region 200 is formed of a transparent conductive material on the polymer region 201. The transparent conductive material includes Indium Tin Oxide (ITO), Tin Oxide (TO), Indium Zinc Oxide (IZO), Indium Tin Zinc Oxide (ITZO), or a combination thereof.

An encapsulation layer or a passivation layer may be further formed on the cathode region 200 in order to protect the OLED 210.

The OLED 210 constructed as described above is supplied with electric power from a rechargeable battery in which electric energy generated by the solar cell 410 is stored, or an external electric power supply unit, and emits light B in the polymer region 201 between the anode region 204 and the cathode region 200.

The OLED 210 is a light emitting layer, in which electric currents with voltages of different polarities are applied to the anode region 204 and the cathode region 200 respectively, so as to enable a hole and an electron injected into the anode region 210 and the cathode region 200, respectively, to be coupled with each other to form an exciton, and the exciton is in a ground state to emit the light B.

The first isolation layer 400 is interposed between the OLED 210 and the solar cell 410 to isolate the OLED 210 and the solar cell 410.

The first isolation layer 400 may be formed of acryl, silicon oxide, or the like.

The solar cell 410 is formed under the first isolation layer 400 in the form of a multilayer structure in order to improve efficiency of the solar cell. The solar cell is provided in the form of a multilayer structure in order to improve the efficiency of the solar cell, and may be formed with two-sided structure in order to absorb both external light and internal light emitted from the OLED 210.

The solar cell 410 is formed under the OLED 210, and receives light A introduced into the solar cell through a pixel boundary region adjacent to a pixel region in which the OLED 210 is provided, so as to convert the light A into electricity, to result in providing additional electric power of the electronic device.

Further, the solar cell 410 absorbs external light A introduced through a circuit board 301 made of a transparent material, and causes a potential difference between an n-type electrode and a p-type electrode to generate electric energy, thereby supplying the electric energy to an external electric power supply unit (not shown) or a rechargeable battery connected to the external electric power supply unit.

That is, the solar cell 410 generally is a semiconductor device for converting solar energy into electric energy, which is made by a junction of a p-type semiconductor and an n-type semiconductor and basically has the same structure as a diode. The solar cell 410 may be formed on a circuit board 301.

The first isolator 400 is preferably made of a transparent isolation film because incident light is made to be transmitted through the first isolator and to be introduced into the solar cell 410.

Particularly, the solar cell 410 may be formed by sequentially layering a positive electrode 405, a p-type region 404, an intrinsic region 403, an n-type region 402, and a negative electrode 401 between isolator 300 on circuit board 301 and isolator 400.

A selection of material for the solar cell 410 is not limited because the solar cell 410 is electrically disconnected with the OLED 210. The solar cell includes at least one of a crystalline silicon solar cell, an amorphous silicon solar cell, a solar cell made of groups 3-5 including GaAs, a solar cell made of a compound of Cu, In, Ga and Se (CIGS), a dye-sensitized solar cell, a solar cell based on organic compound, and a combination thereof.

In the solar cell 410, electrons must be asymmetrically present in a structure of a p-n junction semiconductor layer for a photovoltaic energy conversion. That is, in the p-n junction semiconductor layer, an n-type semiconductor layer has a high electron density and a low hole density, and a p-type semiconductor layer has a low electron density and a high hole density.

Accordingly, in a thermal equilibrium state, an imbalance of an electric charge is generated by diffusion of a carrier due to a concentration gradient in the p-n junction semiconductor layer, and thereby an electric field is formed so that the diffusion of the carrier does not continue to occur.

At this time, when light having a higher energy than a band gap energy (which is an energy difference between a conduction band and a valence band of a material forming the p-n junction semiconductor layer) is emitted into the p-n junction semiconductor layer, electrons receiving the light energy are excited from the valence band to the conduction band. Accordingly, the electrons excited to the conduction band freely move, and holes are generated in a space of the valence band from which the electrons are slipped. The free electrons and the holes are referred to as excess carriers, and the excess carriers are diffused due to the concentration gradient in the conduction band or the valence band. At this time, the excess carries, i.e., electrons excited in the p-type semiconductor and holes generated in the n-type semiconductor, are defined as a minority carrier, while carriers in the p-type or n-type semiconductor before the junction, i.e., p-type hole and n-type electron, are defined as a majority carrier and distinguished from the minority carrier.

Although a flow of the plural carriers is interrupted because of an energy barrier due to the electric field, the electrons which are the p-type minority carrier can move toward the n-type minority carrier. A potential drop occurs due to the diffusion of the minority carrier in the p-n junction semiconductor layer, and the p-n junction semiconductor layer functions as a battery when both electrodes thereof are connected to an external circuit to supply an electromotive force generated by the p-n junction semiconductor layer to the external circuit. Therefore, the electromotive force generated in such a manner is supplied to a battery (not shown) for operating the OLED 210 and a circuit for charging the battery, so that the battery can be automatically charged.

Solar cells 410 according to the embodiment of the present invention as shown in FIG. 1 are formed in correspondence to a lower end of the pixel region and the pixel boundary region

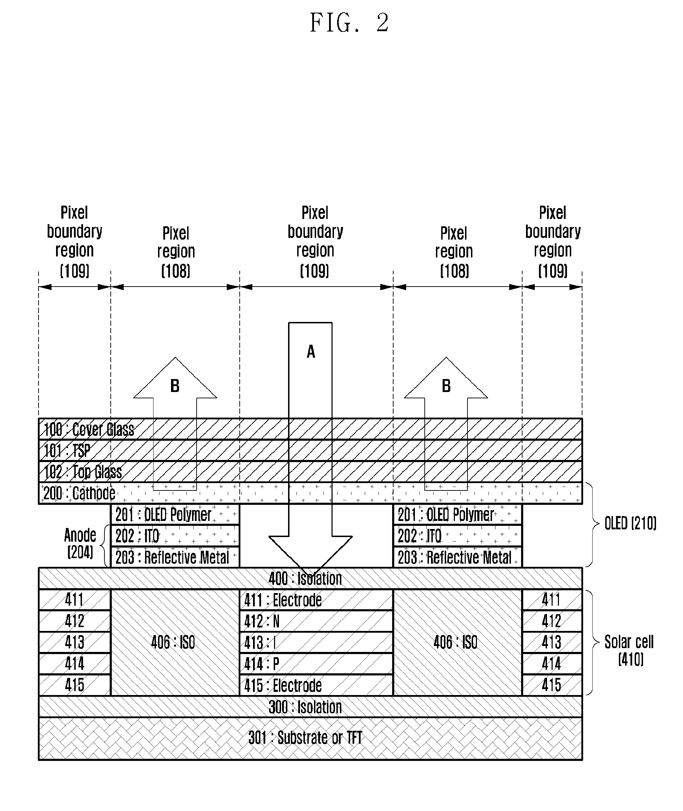

Alternatively, referring to FIG. 2, solar cell 410 may be formed to correspond to the lower end of the pixel boundary region. That is, the solar cell 410 is formed under the lower end of the pixel boundary region, and the isolator 406 may be formed under a lower end of the pixel region. The isolators 406 may be a partitioning region interposed between the solar cells 410 formed like pixels. The isolator 406 may be formed of acryl, silicon oxide, or the like.

The reason for arranging the solar cells at the lower end of the pixel boundary region is because an absorbing ratio of light introduced from an outside is relatively lower than in the pixel boundary region as the OLED 210 is formed in the pixel region. Accordingly, in view of energy efficiency and cost, the solar cells 410 are preferably formed under the lower end of the pixel boundary region which has a high absorbing ratio of the light.

Further, since the solar cells 410 are formed under the lower end of the pixel boundary region, it is possible to prevent deterioration in brightness of light D emitted from the OLED 210.

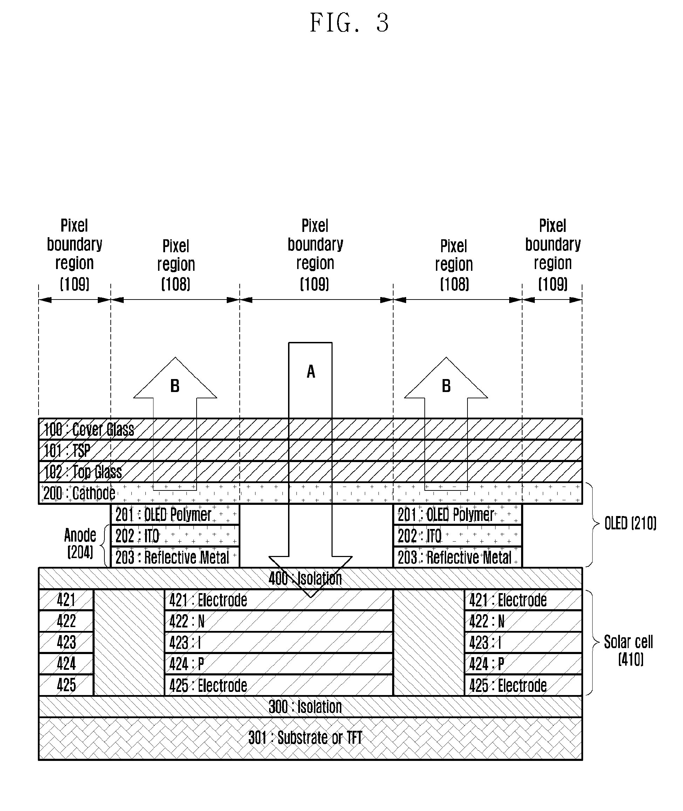

Referring to FIG. 3, the solar cells 410 according to the present invention may have a structure in which they are formed to correspond to a portion of the pixel region and a portion of the pixel boundary region and under the lower end of the pixel boundary region and the pixel region That is, some of the solar cells 410 may be formed just under the OLED 210, and the remaining solar cells 410 may be formed just under the pixel boundary region.

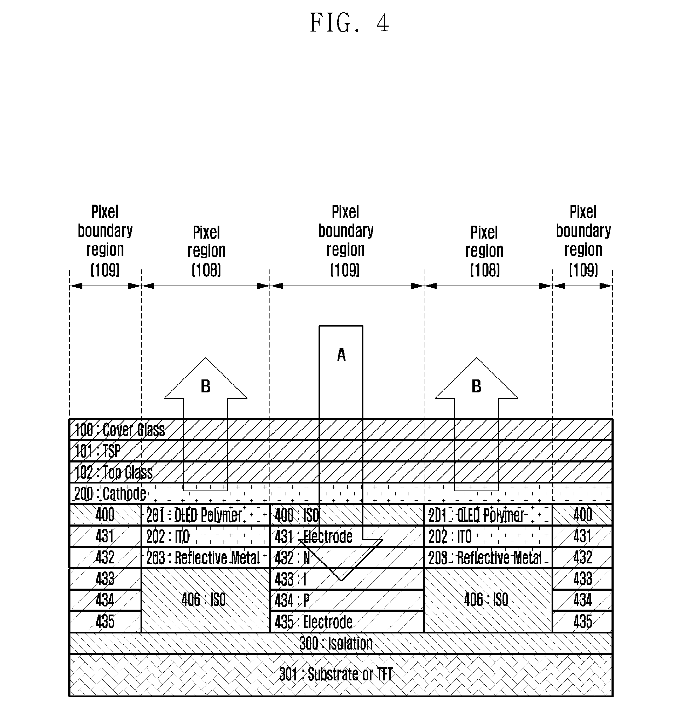

Referring to FIG. 4, the solar cells 410 according to the embodiment of the present invention are formed in the pixel boundary region. That is, the solar cells 410 may be formed at both sides of the OLED 210 which is a pixel region. In such a structure, as the solar cells 410 are formed in the pixel boundary region, the solar cells 410 are arranged nearer to an upper side of the OLED display apparatus in comparison with the solar cells 410 previously illustrated in FIGS. 1 to 3. Therefore, there is an effect in that efficiency of the solar cells 410 is improved.

Further, since the solar cells 410 according to this embodiment are arranged in the pixel boundary region which is an empty space in comparison to the previously illustrated solar cells 410 arranged in correspondence to a lower end of the OLED 210, there are advantages in that an overall thickness of the OLED display apparatus can be reduced, and also the thickness of the OLED display apparatus with the solar cells can be reduced.

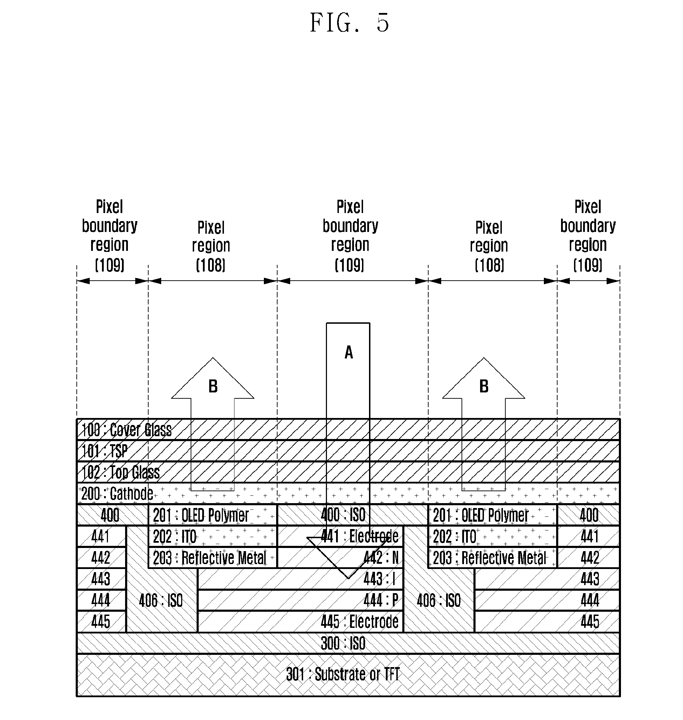

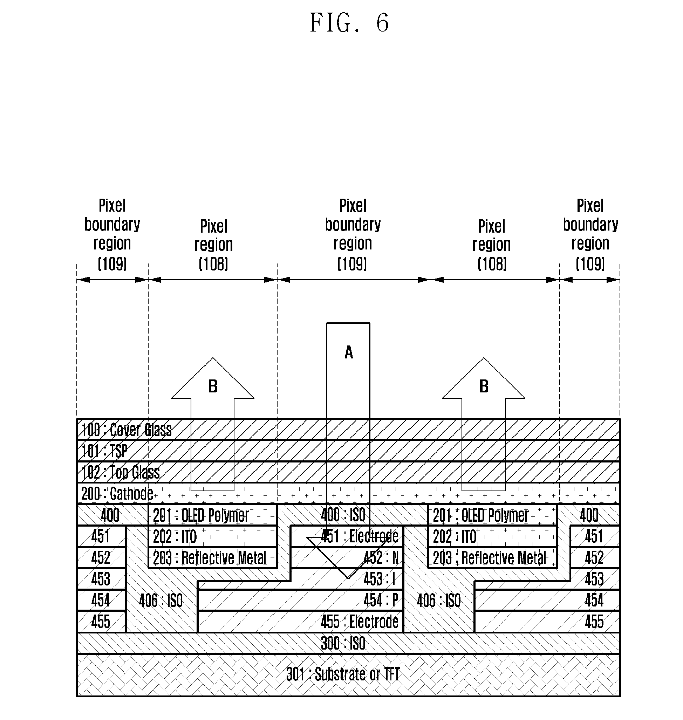

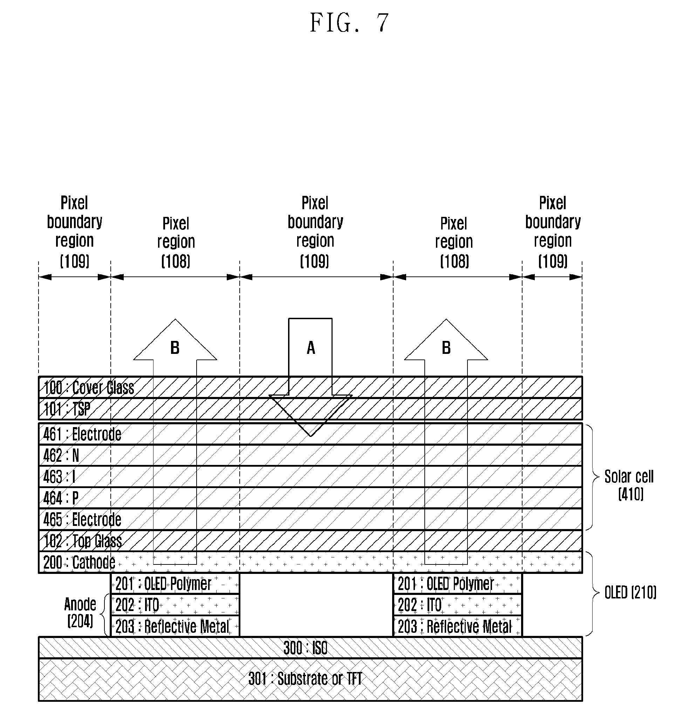

Referring to FIG. 5, the solar cell 410 may be formed under the pixel boundary region and the pixel region, i.e., formed just under the pixel region simultaneously when it is formed under the pixel boundary regionThat is, some of the solar cells 410 may be formed just under the OLED 210, and the remaining solar cells 410 may be formed under the pixel boundary region. The isolators 406 may be a partitioning region interposed between the solar cells 410 formed like pixels. As shown in FIG. 6, the isolator 406 may be formed between the solar cell 401 and the OLED 210. That is, the isolator 406 functions to isolate the solar cell 401 and the OLED 210, and is arranged to surround a periphery of the solar cell 401 Referring to FIG. 7, the solar cell 410 according to an embodiment of the present invention is formed on the OLED 210. Particularly, the solar cell 410 is formed on a substrate 301, the OLED 210 and a top glass 102, and a touch panel 101 and a cover glass 100 may be formed on the solar cell 410.

At this time, the top glass between the solar cell 410 and the OLED 210 functions as a substrate for the solar cell 410.

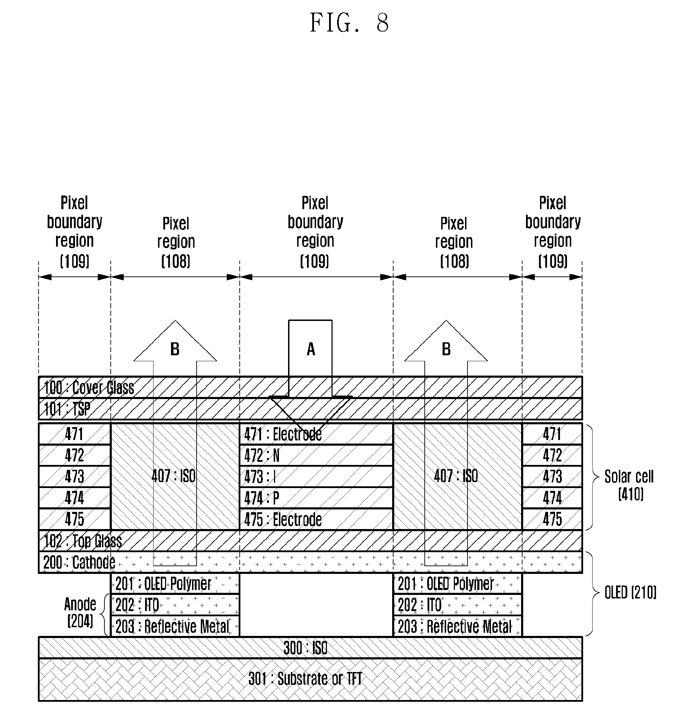

FIG. 8 shows a structure of the solar cell 410 which is partially formed and which has been shown in FIG. 7, in which a partitioning region 407 is formed between the solar cells 410 formed like the pixels. The partitioning region 407 is formed of an isolation material such as silicon oxide, silicon nitride, acrylic based resin, or the like. The solar cell 410 is formed in a region corresponding to an upper portion of the pixel boundary region, and the partitioning region 407 may be formed in a region corresponding to an upper portion of the pixel region. Here, the partitioning region 407 corresponding to an upper portion of the OLED 210 may be formed of a transparent isolator, so as to transmit the light B emitted from the OLED 210. As shown in FIGS. 7 and 8, when the solar cell 410 is formed on the upper portion of the OLED 210, it is possible to increase an amount of light A incident to the solar cells 410. Hereinafter, a process of manufacturing the OLED display apparatus with the solar cell according to an embodiment of the present invention will be described with reference to FIGS. 1 to 6.

Referring to FIGS. 1 to 6, in the process of manufacturing the OLED display apparatus with the solar cells, the solar cells 410 which convert the light into electricity to assist electric power of the OLED display are formed on a substrate.

Although electrodes comprising the solar cell 410 may be formed of a single thin-film, the electrodes may be formed of a multi-layered thin-film having a transparent isolation layer/a transparent electrode/a transparent isolation layer. Since the solar cell is formed of the transparent electrode and the transparent isolation layer, it is possible to further absorb light incident through a lower portion of the OLED display apparatus and to improve light absorbing capability.

After the solar cells 410 are deposited, a part of the solar cell 410 is etched in order to form pixel structures, and then the isolator 406 is deposited on the etched part of the solar cell. At this time, the part of the solar cell corresponding to the pixel region is etched and a semitransparent or transparent isolator 406 is deposited on the etched part of the solar cell, thereby forming the solar cell 410 only under the pixel boundary region which has an excellent light absorbing ratio in view of energy efficiency and cost. As shown in FIG. 6, the isolator 406 may be formed between the solar cell 410 and the OLED 210.

Further, the isolator 300 may be further deposited between the solar cell 410 and the substrate 301.

When the solar cell 410 is formed, an isolator 400 is deposited on the solar cell 410 and the OLED 210 is deposited in the pixel region on the isolator 400,except for the pixel boundary region.

The OLED 210 is formed by sequentially depositing an anode region 204 comprising an ITO transparent electrode 202 and/or a reflective metal 203, a polymer region 201 for emitting light, and a cathode region 200 comprising a transparent electrode or a semitransparent electrode. At this time, the uppermost cathode region 200 may be formed on an upper portion of the OLED display apparatus including the pixel region and the pixel boundary region.

When the OLED 210 is formed, a display unit including a top glass 102, a touch panel 101 and a cover glass 100 are formed on the pixel region and the pixel boundary region.

Hereinafter, a process of manufacturing the OLED display apparatus with the solar cell according to another embodiment of the present invention will be described with reference to FIGS. 7 to 8.

Referring to FIG. 7, in the process of manufacturing the OLED display apparatus with the solar cell, the OLED 210 is formed in the pixel region except for the pixel boundary region on the substrate 301. Here, an isolator 300 may be formed between the substrate 301 and the OLED 210.

A top glass 102 is formed on a cathode 200 of the OLED 210. In turn, the solar cell 410 may be formed on the top glass 102, and a touch panel 101 and a cover glass 100 may be formed on the solar cell 410. Here, the top glass 102 may function as the substrate for the solar cell 410.

Particularly, the solar cell 410 may be prepared in such a manner that a positive electrode 465[], a p-type region 464, an intrinsic region 463, an n-type region 462, and a negative electrode 461 are sequentially formed on the top glass 102.

Referring to FIG. 8, here, a process of etching a part of the solar cell 410 shown in FIG. 7 in order to form a pixel structure and depositing an isolator 407 in the etched region may be further included. Particularly, the part of the solar cell 410 corresponding to the pixel region is etched and the semitransparent or transparent isolator 407 is deposited in the etched region, thereby facilitating transmission of the light emitted from the OLED 210 through the isolator 407.

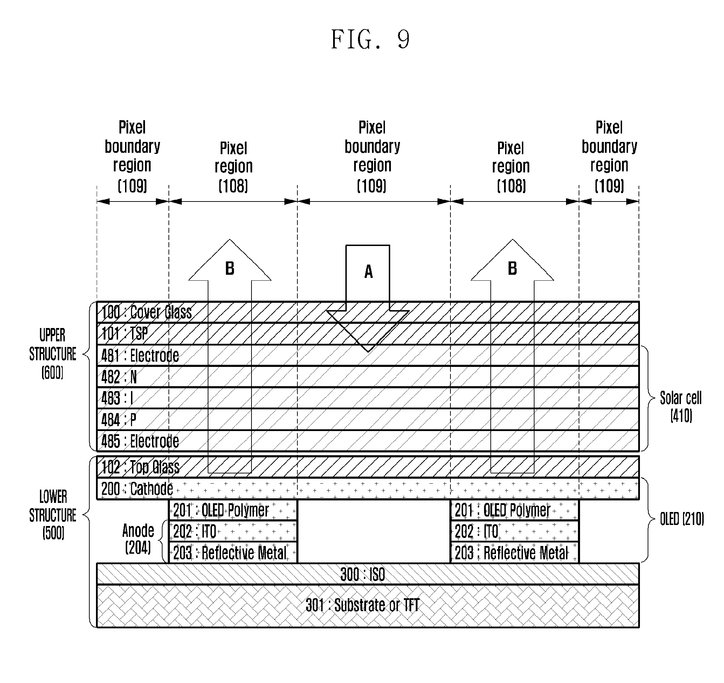

Hereinafter, a process of manufacturing the OLED display apparatus with the solar cell according to another embodiment of the present invention will be described with reference to FIGS. 9 to 10.

Referring to FIG. 9, in the process of manufacturing the OLED display apparatus with the solar cell according to another embodiment of the present invention, the OLED 210 may be formed in the pixel region except for the pixel boundary region on the substrate 301. Here, an isolator 300 may be further formed between the substrate 301 and the OLED 210. A top glass 102 is formed on the pixel boundary region and the pixel region including the OLED 210, so as to form a lower structure of the OLED display apparatus.

After an upper structure 600 and the lower structure 500 are provided by preparing the upper structure 600 separately from the lower structure 500, the upper structure 600 may be made to cohere on the lower structure 500 through an upside-down process. Here, the coherence of the upper structure 600 to the lower structure 500 may be performed by using an adhesive or thermal compression method.

The upper structure 600 is separated from the substrate 310 on which the OLED 210 is formed, and is prepared by sequentially forming a cover glass 100, a touch panel 101, and the solar cell 410.

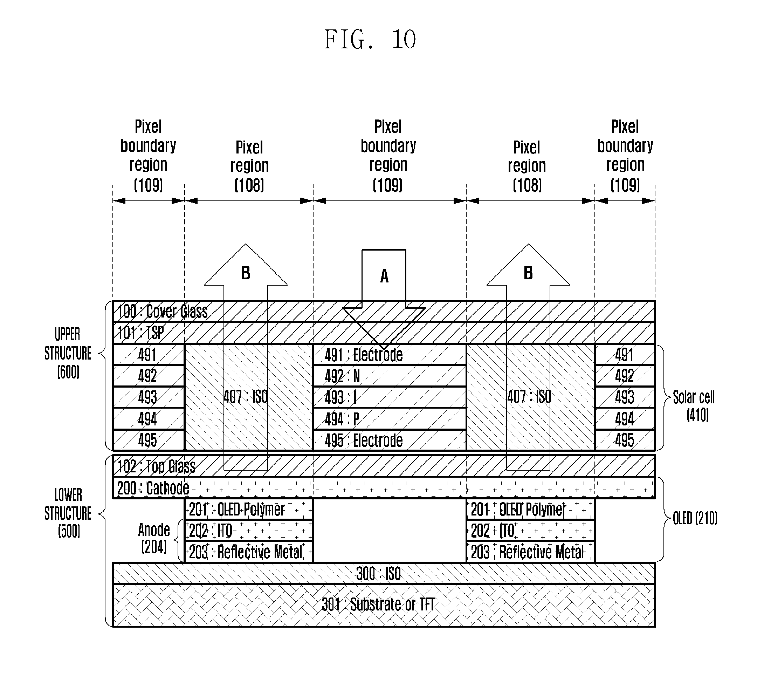

Referring to FIG. 10, here, a process of etching a part of the solar cell 410 shown in FIG. 9 and depositing an isolator 407 in the etched region, in order to form a pixel structure may be further included. Particularly, the part of the solar cell 410 corresponding to the pixel region is etched and the semitransparent or transparent isolator 407 is deposited in the etched region, thereby facilitating transmission of the light emitted from the OLED 210 through the isolator 407. While certain embodiments of the present invention shown and described in this specification and the drawings correspond to specific examples present in order to easily explain technical contents of the present invention, and to help an understanding of the present invention, they are not intended to limit the scope of the present invention. That is, it will be obvious to those skilled in the art to which the present invention belongs that different modifications can be achieved based on the technical spirit of the present invention.

## Claims

1. An Organic Light Emitting Diode (OLED) display apparatus with a solar cell, the OLED display apparatus comprising:
an OLED display unit which includes a pixel region formed of an OLED and a pixel boundary region partitioning the pixel region, a touch panel through which light emitted from the OLED is transmitted, and at least one glass; and
a solar cell for converting incident light into electricity, which is formed adjacent to the OLED display unit.

2. The OLED display apparatus as claimed in claim 1, wherein the solar cell is provided under a lower portion of the OLED display unit.

3. The OLED display apparatus as claimed in claim 2, further comprising a transparent isolation layer interposed between the solar cell and the OLED display unit.

4. The OLED display apparatus as claimed in claim 2, wherein the solar cell is provided in a location corresponding to a lower portion of the pixel boundary region of the OLED display unit, and comprises an isolation layer under the pixel region.

5. The OLED display apparatus as claimed in claim 2, wherein the solar cell is provided in a location corresponding to a lower portion of the pixel boundary region and the pixel region of the OLED display unit, and comprises an isolation layer interposed between solar cells spaced apart from each other.

6. The OLED display apparatus as claimed in claim 1, wherein the solar cell is partially formed on a same horizontal plane as the OLED display unit.

7. The OLED display apparatus as claimed in claim 6, further comprising an isolation layer interposed between the solar cell and the OLED display unit.

8. The OLED display apparatus as claimed in claim 1, wherein the solar cell is provided on the OLED display unit.

9. The OLED display apparatus as claimed in claim 8, wherein a top glass, the solar cell, a touch panel, and a cover glass are sequentially formed on the OLED display unit.

10. The OLED display apparatus as claimed in claim 9, wherein the solar cell is provided on the pixel boundary region.

11. The OLED display apparatus as claimed in claim 8, wherein the solar cell comprises an isolation layer interposed between the solar cells spaced from each other on the pixel region.

12. A method of manufacturing an Organic Light Emitting Diode (OLED) display apparatus with a solar cell, the method comprising:
forming a solar cell on a substrate;
forming an Organic Light Emitting Diode (OLED) on the solar cell; and
forming at least one glass and a touch panel through which light emitted from the OLED is transmitted, on the OLED.

13. The method as claimed in claim 12, wherein forming the solar cell further comprises etching a part of the solar cell and depositing a semitransparent or transparent isolator in the etched region of the solar cell.

14. The method as claimed in claim 13, wherein in the etching of a part of the solar cell, the part of the solar cell corresponding to a lower portion of the OLED is etched.

15. A method of manufacturing an Organic Light Emitting Diode (OLED) display apparatus with a solar cell, the method comprising:
forming a solar cell on a substrate;
etching a part of the solar cell, and forming an isolation layer on the etched part of the solar cell and an Organic Light Emitting Diode (OLED) on the isolation layer; and
forming at least one glass and a touch panel through which light emitted from the OLED is transmitted, on the OLED.
